# EUROPÄISCHE PATENTANMELDUNG

(11) **EP 4 428 903 A1**
(43) Veröffentlichungstag der Anmeldung: **11.09.2024**
(21) Anmeldenummer: 23160550.2
(22) Anmeldetag: 07.03.2023
(51) Int. Cl.: H01L 21/48, H01L 23/373, H01L 23/46

(54) **KÜHLKÖRPER FÜR EIN ELEKTRONIKBAUTEIL**

(71) Anmelder: Siemens Aktiengesellschaft, 80333 München (DE)
(72) Erfinder: Boschert, Stefan, 85579 Neubiberg (DE); Schwarz, Markus, 80798 München (DE); Stegmeier, Stefan, 81825 München (DE); Walbrecker-Baar, Christian, 85757 Karlsfeld (DE); Beckert, Thomas, 90461 Nürnberg (DE); Nannen, Hauke, 90475 Nürnberg (DE)
(74) Vertreter: Siemens Patent Attorneys

(57) **Zusammenfassung**

Die Erfindung betrifft einen Kühlkörper für ein Elektronikbauteil,
aufweisend:
- Einen Metallschaum (1) und
- ein thermisch leitfähiges Material (2),
wobei das thermisch leitfähige Material (2) von zumindest einem Teilbereich des Metallschaums (1) durchwachsen ist.

Außerdem betrifft die Erfindung eine zugehörige Herstellung.

## Beschreibung

Unabhängig vom grammatikalischen Geschlecht eines bestimmten Begriffes sind Personen mit männlicher, weiblicher oder anderer Geschlechteridentität mit umfasst.

### HINTERGRUND DER ERFINDUNG

### Gebiet der Erfindung

Die vorliegende Erfindung betrifft einen Kühlkörper für ein Elektronikbauteil. Die Erfindung betrifft außerdem eine zugehörige Herstellung.

### Beschreibung des Stands der Technik

Die Lebensdauer und Zuverlässigkeit von elektronischen Bauteilen, auch als Elektronikbauteil bezeichenbar, ist im Wesentlichen von deren Wärmemanagement abhängig. Aufgrund der Miniaturisierung und der damit steigenden Verlustleistungsdichte gewinnt das thermische Management elektronischer Bauteile mehr und mehr an Bedeutung.

Module mit elektronischen Halbleiterbauelementen, wie Leistungshalbleiter, reagieren bekanntermaßen sehr empfindlich auf zu hohe Betriebstemperaturen. Die Temperaturkontrolle der Elektronikbausteine ist zwingend erforderlich, um Fehlfunktionen der Bauteile oder einer gesamten Baugruppe, im Worst-Case-Szenario einen thermisch verursachten Totalschaden, zu vermeiden.

Etliche Entwärmungsaufgaben werden durch bekannten Strangkühlkörper aus Aluminium gelöst. Strangkühlkörper, auch als Extrusionskühlkörper bezeichnet, sind in der Praxis die am häufigsten eingesetzte Methode zur Bauteilentwärmung und basieren auf dem Wirkprinzip der freien Konvektion.

Steigen allerdings die abzuführenden Verlustleistungen, so steigen gleichfalls die geometrischen Abmessungen sowie das Gewicht des notwendigen Kühlkörpers. Ab einem gewissen Punkt, welcher durch die thermischen Randbedingungen hervorgerufen wird, treten allerdings die Strangkühlkörper und das damit verbundene Wirkprinzip an die Leistungsgrenze des machbaren. In diesem Fall können Kühlkörper mit einem Lüftermotor versehen werden, was die Wärmeableitleistung je nach Luftgeschwindigkeit und Luftvolumen steigern kann, letztendlich aber nur ein Behelf darstellt.

Auch additive Methoden, wie insbesondere selektives Laserschmelzen (SLM), werden verwendet, um maßgeschneiderte Kühler aufzubauen. Speziell die graduelle Verteilung der Wärme und die Anpassung an die Applikation ist hier von Vorteil. Jedoch ergeben sich aufgrund der hohen Pulverkosten und der langsamen Herstellmethode deutliche Limitierungen hinsichtlich einer Massenanwendung.

Neuere Kühlkonzepte benutzen offenporigen Schaum als Kühlkörper. Aufgrund der großen Oberfläche ist dieser prädestiniert für Kühlaufgaben. Nachteile bieten aber die durch das Herstellungsverfahren vorhandenen Hohlräume in den Schaum-Stegen, was wiederrum eine geringere Wärmeleitfähigkeit bedingt. Ein weiterer Nachteil ist eine schlechte Einkopplung der Wärme an der Baseplate, auch als Basisplatte bezeichenbar. Dieser Effekt kann teilweise durch Variation der Porengröße reduziert werden. Zusätzlich findet nur ein geringer Transport der Wärme in die distalen Gegenden, in zur Baseplate weiter entfernten Gegenden, des Schaums statt.

Eine Kombination von Pin-Fin Kühlern und Metallschaum kann dies verbessern. Diese Kombination ist aber sehr teuer und mit hohem industriellem Aufwand verbunden.

Die Aufgabe der Erfindung besteht darin, eine Lösung für einen verbesserten Kühlkörper für Elektronikbauteile bereitzustellen.

### ZUSAMMENFASSUNG DER ERFINDUNG

Die Erfindung ergibt sich aus den Merkmalen der unabhängigen Ansprüche. Vorteilhafte Weiterbildungen und Ausgestaltungen sind Gegenstand der abhängigen Ansprüche. Ausgestaltungen, Anwendungsmöglichkeiten und Vorteile der Erfindung ergeben sich aus der nachfolgenden Beschreibung und den Zeichnungen.

Die Erfindung betrifft einen Kühlkörper für ein Elektronikbauteil, aufweisend:
- Einen Metallschaum und
- ein thermisch leitfähiges Material, wobei das thermisch leitfähige Material von zumindest einem Teilbereich des Metallschaums durchwachsen ist.

Dadurch, dass das thermisch leitfähige Material von zumindest einem Teilbereich des Metallschaums durchwachsen ist, kann der Kühlkörper auch als aus einem Kompositwerkstoff ausgebildet beschrieben werden. Hiernach ist der Kühlkörper ausgebildet aus einem Kompositwerkstoff, der Kompositwerkstoff aufweisend:
- Eine erste Phase, ausgebildet als der Metallschaum und
- eine zweite Phase, ausgebildet als das thermisch leitfähige Material,
wobei das thermisch leitfähige Material von dem Metallschaum durchwachsen ist.

Der Metallschaum hat die Struktur eines Schaums und weist das Material Metall auf. Die Struktur des Schwamms ist gekennzeichnet durch Poren uns Stege, wobei die Stege die Poren verbinden.

"Wobei das thermisch leitfähige Material von dem Metallschaum durchwachsen ist" ist auch beschreibbar als, dass der Metallschaum das thermisch leitfähige Material durchzieht oder durchläuft. Andersherum ausgedrückt: Die Struktur des Metallschaums mit ihren Stegen und Poren von dem thermisch leitfähigen Material umgeben, umhüllt oder eingebettet ist. Die Struktur ist auch als Gerüststruktur bezeichenbar, da der Schaum ein Gerüst aus Poren und Stegen bildet.

Die Erfindung ist nicht so zu verstehen, dass das thermisch leitfähige Material den Metallschaum als Ganzes umhüllt, stattdessen wird die Struktur umhüllt. Außerdem weist der Metallschaum an sich das thermisch leitfähige Material nicht auf, es liegt nicht "innerhalb" der Gerüststruktur des Schaums, sondern umschließt diese. Der Kühlkörper hingegen weist das thermisch leitfähige Material auf.

Ein Aspekt der Erfindung besteht darin, dass das thermisch leitfähige Material in Bezug auf das Volumen aufgrund seiner höheren Dichte, im Gegensatz zum Metallschaum, im Folgenden auch als Schaum bezeichnet, eine höhere Wärmeleitfähigkeit besitzt. Dadurch kann die Wärme auch in die distalen Gegenden des Schaums geleitet werden. Da sich das thermisch leitfähige Material im Kühlkörper befindet, erfolgt so eine Verteilung der Wärme über das thermisch leitfähige Material. Der Schaum bleibt durch die Strukturierung offenen und kann dadurch Wärme über die große Oberfläche an die Umgebung abgeben. Des Weiteren können Wärmespitzen von dem thermisch leitfähigen Material aufgenommen und anschließend über den Schaum an die Umgebung abgegeben werden.

In einer Weiterbildung der Erfindung ist der Metallschaum aus einer Struktur besteht, welche durch Poren, die über Stege verbunden sind, gekennzeichnet, wobei das thermisch leitfähige Material an der Struktur anliegt.

Die Struktur, welche durch Poren, die über Stege verbunden sind, gekennzeichnet ist, kann auch als eine poröse Struktur bezeichnet werden.

Da das thermisch leitfähige Material an der Struktur anliegt folgt, dass das thermisch leitfähige Material die Struktur des Metallschaums umschließt, auch als umhüllt bezeichenbar.

In einer weiteren Weiterbildung der Erfindung gilt für das thermisch leitfähige Material, dass es:
- die Struktur des Metallschaums vollständig auffüllt und/oder
- an der Struktur des Metallschaums als Schicht anliegt und/oder
- die Struktur des Metallschaums umschließt und/oder
- die Poren des Metallschaums in dem zumindest einen Teilbereich schließt und/oder
- die Poren des Metallschaums in dem zumindest einen Teilbereich zumindest teilweise schließt und/oder
- die Poren des Metallschaums in dem zumindest einen Teilbereich offen behält und/oder
- die Poren des Metallschaums in dem zumindest einen Teilbereich zumindest teilweise offen behält.

Dass das thermisch leitfähige Material die Struktur des Metallschaums vollständig auffüllt, bedeutet, dass der Kühlkörper an sich ein volles, kompaktes Material ist.

Dass das thermisch leitfähige Material an der Struktur des Metallschaums als Schicht anliegt, ist so zu verstehen, dass eine Schichtdicke der Schicht geringer als halber Porendurchmesser/Stegabstand ist. Die Struktur wird in diesem Fall nicht vollständig aufgefüllt. Die Schichtdicke hat eine Größe der Größenordnung geringer als die Dicke der Stege des Metallschaums, in der Regel kleiner einem Millimeter.

Die gewünschte Schichtdicke auf Stegen und Poren des Schaums ist bei einer Herstellung durch mehrfaches Überfahren einer Spritzdüse für das thermisch leitfähige Material, durch die Zuführung der Pulvermenge des thermisch leitfähigen Materials, die Vorschubgeschwindigkeit aber auch durch die Plasmaparameter des thermisch leitfähigen Materials einstellbar. Zudem wird ein Eindringen der Partikel des thermisch leitfähigen Materials maßgeblich durch die Porenweite des Schaumes bestimmt.

Dass das thermisch leitfähige Material die Poren des Metallschaums Poren schließt, bedeutet, dass der Metallschaum an jenen Stellen somit keine Poren oder keine poröse Struktur mehr aufweist. Wird die gesamte Struktur aufgefüllt, so ist auch der Bereich der Stege geschlossen.

Dass das thermisch leitfähige Material die Poren des Metallschaums offen behält, bedeutet, dass: Der Metallschaum somit weiterhin Poren oder weiterhin eine poröse Struktur.

In einer weiteren Weiterbildung der Erfindung verläuft das thermisch leitfähige Material in Form von:
- mindestens einer Lamelle durch den Metallschaum und/oder
- mindestens eines Zylinders durch den Metallschaum und/oder
- mindestens eines Kegels durch den Metallschaum und/oder
- einer Deckschicht an einer Außenseite des Metallschaums.

Dies ist so zu verstehen, dass eine gedachte Umhüllung des Bereichs, in dem das thermisch leitfähige Material angeordnet ist, auch als ein Volumen vorstellbar, in dieser Form ausgebildet ist. Die Form ist auch als ein Verlauf des thermisch leitfähige Material bezeichenbar.

Die Deckschicht kann für eine spätere Ankontaktierung (insbesondere durch Löten, Sintern oder Schweißen), an das zu kühlende Elektronikbauteil, verwendet werden.

In einer weiteren Weiterbildung der Erfindung ist das thermisch leitfähige Material ausgebildet als:
- mindestens ein Polymer und/oder
- ein Polymerkleber und/oder
- ein Polymer kombiniert mit Metalpartikeln und/oder
- ein Polymer kombiniert mit einem Phase-Change-Material und/oder
- mindestens ein Metall und/oder
- eine Metalllegierung.

Ein Phase-Change-Material, insbesondere ein Paraffin, wird insbesondere in einem Polymer als Kern eingeschlossen. In diesem Fall füllt das Polymer die Struktur des Schaums vollständig auf und schafft damit einen abgedichtet Raum. Innerhalb dieses Raums, im Kern, ist das Phase-Change-Material anordenbar. Dies ist von Vorteil, da Phase-Change-Materials bei kurzzeitigen Temperaturspitzen Wärme zwischenpuffern können. Eine strukturiert, d.h. in einer vorgebaren Forum und Struktur, insbesondere ein ovales Volumen, ein Kegel oder ein Zylinder, eingebrachtes Phase-Change-Material dehnt sich gezielt aus. Das ist von Vorteil, da ein Phasenübergang meist mit einem höheren Volumengewinn einher geht und das gezielte Ausdehnen damit das Produkt langlebiger macht.

Ein Polymer mit Metalpartikeln ist von Vorteil, da eine hohe Metalldichte in den gewollten Wärmeleitregionen erzeugen werden kann, welches durch ein Polymer-Pastensystem allein wegen einer zu hohen Viskosität der Paste nicht möglich wäre. Außerdem steigt so die elektrische Leitfähigkeit.

Mehrere Metalle und eine Metalllegierung haben jeweils den Vorteil, dass ein hoher Schmelzpunkt und/oder eine hohe Festigkeit erreichbar ist.

In einer weiteren Weiterbildung der Erfindung weist der Metallschaum auf:
- eine metallische Beschichtung, insbesondere ausgebildet als:
   o eine Vernickelung und/oder
   o eine Verzinnung und/oder
   ∘ eine Siliziumdioxidbeschichtung.

Hierdurch lassen sich die mechanischen, elektrischen und/oder thermischen Eigenschaften des Schaums anpassen.

In einer weiteren Weiterbildung der Erfindung ist das thermisch leitfähige Material ausgebildet, Wärme in dem Metallschaum zu verteilen.

Das thermisch leitfähige Material besitzt aufgrund seiner höheren Dichte in Bezug auf sein Volumen, im Gegensatz zum Metallschaum eine höhere Wärmeleitfähigkeit. Dadurch kann die Wärme auch in die distalen Gegenden des Schaums geleitet werden. Der Schaum hat durch die Struktur eine größere Oberfläche als das thermisch leitfähige Material und kann dadurch Wärme über die Oberfläche an die Umgebung abgeben. Des Weiteren können Wärmespitzen von dem thermisch leitfähigen Material aufgenommen und anschließend über den Schaum an die Umgebung abgegeben werden.

In einer weiteren Weiterbildung der Erfindung ist der Metallschaum ausgebildet, von einem Kühlmedium durchströmt zu werden.

Die poröse Struktur des Schaums erlaubt ein Durchströmen. Dies erzeugt eine Kühlwirkung.

In einer weiteren Weiterbildung der Erfindung weist der Kühlkörper außerdem eine Kontaktfläche auf, wobei die Kontaktfläche ausgebildet ist, mit einer Basisplatte des Elektronikbauteils in Kontakt zu treten.

Die Basisplatte ist auch als Baseplate bezeichenbar. Auf der Baseplate sind wärmeempfindliche, zu kühlende Komponenten des Elektronikbauteils angeordnet. Der Kühlkörper ist vorzugsweise auf der entgegengesetzten Seite der Baseplate wie die wärmeempfindlichen, zu kühlenden Komponenten des Elektronikbauteils angeordnet.

In einer weiteren Weiterbildung der Erfindung ist ein längster Querschnitt einer Form des thermisch leitfähigen Materials senkrecht zu der Kontaktfläche des Kühlkörpers angeordnet.

Die Form wird durch einen Verlauf des thermisch leitfähigen Materials durch den Metallschaum bestimmt. Die Form ist dabei so zu verstehen, dass eine gedachte Umhüllung des Bereichs, in dem das thermisch leitfähige Material angeordnet ist, auch als ein Volumen vorstellbar, eine Form bilden. Dies hat den Vorteil, dass der längste Querschnitt von der Kontaktfläche weg und somit in den Metallschaum hinein verläuft und so Wärme abtransportiert wird. Würde das thermisch leitfähige Material parallel zu der Kontaktfläche angeordnet sein, würde die Wärme nicht vom Elektronikbauteil wegtransportiert werden.

Die Erfindung umfasst außerdem eine Herstellung eines Kühlkörpers für ein Elektronikbauteil,
mit den Schritten:
- Ein Bereitstellen eines Metallschaums, wobei der Metallschaum aus einer Struktur besteht, welche durch Poren, die über Stege verbunden sind, gekennzeichnet ist, und
- ein Einbringen eines thermisch leitfähigen Materials in zumindest einen Teilbereich des Kühlkörpers, wobei das thermisch leitfähige Material nach dem Einbringen an der Struktur anliegt.

Es erfolgt somit ein Einbringen in den Kühlkörper und in die poröse Struktur des Metallschaums. Das Einbringen ist auch als Aufbringen bezeichenbar.

Da das thermisch leitfähige Material nach dem Einbringen an der Struktur anliegt, umschließt, auch als umhüllt bezeichenbar, es die Struktur des Metallschaums somit. Der Metallschaum an sich weist dabei das thermisch leitfähige Material nicht auf, es liegt nicht "innerhalb" der Gerüststruktur des Schaums, sondern umschließt diese.

Dadurch, dass das thermisch leitfähige Material an der Struktur des Metallschaums anliegt, ist das thermisch leitfähige Material von dem Metallschaum durchwachsen.

In einer Weiterbildung der Erfindung erfolgt das Einbringen mittels:
- eines Polymer-Dispensen-Verfahrens und/oder
- Thermischen Metallspritzens.

Das Polymer-Dispensen-Verfahren ist insbesondere als ein gezieltes sequenzielles Aufbringen einer flüssigen, zähen Polymermasse (Polymerpaste) ausgebildet. Dadurch lassen sich vorgebare Strukturen und Formen erzeugen. Die Polymerpaste wird insbesondere nach dem Einbringen durch ein Curing (d.h. ein Erhitzen) ausgehärtet.

Das thermische Metallspritzverfahren ist auch als thermisches Metallspritzen und auch als thermisches Metallsprühen bezeichenbar. Das thermische Spritzen gehört nach DIN EN 657 zu den Beschichtungsverfahren, bei dem ein Spritzzusatz plastifiziert, angeschmolzen oder geschmolzen auf die (Substrat-)Oberfläche geschleudert wird. Die Haftung der Spritzschicht geschieht durch mechanische Verklammerung, Adhäsionskräfte sowie geringe metallurgische Wechselkräfte. Die Spritzverfahren werden anhand der Energiequelle eingeteilt (z.B. Lichtbogen, Flamme, Plasma, Gasströmung, ...) und deshalb typischerweise als thermisches Metallsprühen bezeichnet.

In einer weiteren Weiterbildung der Erfindung weist die Herstellung mindestens einen der weiteren Schritten auf:
- ein Aufsetzen des Metallschaums auf eine Basisplatte des Elektronikbauteil vor dem Einbringen des thermisch leitfähigen Materials und/oder
- ein Einbringen von Metallpartikeln in den zumindest einen Teilbereich vor dem Einbringen des thermisch leitfähigen Materials und/oder
- ein Einbringen eines Phase-Change-Materials in den zumindest einen Teilbereich vor dem Einbringen des thermisch leitfähigen Materials und/oder
- eine chemische Vorbehandlung, insbesondere Hydrophobisierung, Hydrophilisierung oder Oxidation, des Metallschaums vor dem Einbringen des thermisch leitfähigen Materials und/oder
- ein Bereitstellen einer Schablone für das und vor dem Einbringen des thermisch leitfähigen Materials und/oder
- ein Erhitzen nach dem Einbringen des thermisch leitfähigen Materials zur Verfestigung oder zur Wärmebehandlung des thermisch leitfähigen Materials und/oder
- ein Anbringen, insbesondere durch Löten, Sintern oder Schweißen, des Metallschaums an einer Basisplatte des Elektronikbauteil nach dem Einbringen des thermisch leitfähigen Materials und/oder
- für einen Metallschaum, welcher Aluminium aufweist: Ein Eloxieren.

Die Basisplatte ist auch als Baseplate bezeichenbar.

Die Metallpartikeln werden insbesondere in Form von einem Metallpulver bereitgestellt. Das Metallpulver wird insbesondere von oben eingestreut oder durch ein Bestäuben eingebracht. Insbesondere wird das Metallpulver nachfolgend mittels dem ebenfalls von oben aufgebrachtem thermisch leitfähigem Material fixiert, hier als Underfiller bezeichenbar. Alternativ kann das Metallpulver mit dem leitfähigen Material vermischt werden. Dies hat den Vorteil, dass das gemischte Material zäher wird und die Verteilung der Metallpartikel gleichmäßig ist.

Das Erhitzen zur Verfestigung ist bei Polymeren auch als Curing bezeichenbar. Dabei erfolgte ein Entfernen von Lösemitteln.

Die nachträgliche Wärmebehandlung hat den Vorteil, dass eine hohe Güte, der durch das thermisch leitfähige Material gebildeten thermischen Pfaden erreicht wird.

Die chemische Vorbehandlung, insbesondere Hydrophobisierung, Hydrophilisierung oder Oxidation, des Metallschaums ist von Vorteil, da ein Polymer anschließend einfacher eingebracht werden kann, indem es an den vorgesehenen Stellen wechselwirkt (chemisch / mechanisch "anhaftet").

In einer weiteren Weiterbildung der Erfindung erfolgt das Einbringen thermisch leitfähigen Materials sequenziell.

Ein sequenzielles Einbringen kann auch als ein wiederholtes Einbringen bezeichnet werden. Es erfolgen Sequenzen von Einbringphasen. Zwischen den Einbringphasen erfolgt ein Aushärten des eingebrachten thermisch leitfähigen Materials. So sind vorgebare Formen und Strukturen des thermisch leitfähigen Materials erreichbar.

In einer weiteren Weiterbildung der Erfindung erfolgt eine Herstellung eines erfindungsgemäßen Kühlkörpers.

Die Erfindung bietet zusammengefasst somit einen effizienten Weg zur Wärmeabfuhr und um dem Wärmeaufkommen eines Elektronikbauteils entgegenzuwirken.

Der vorgeschlagene Kühlkörper kombiniert die Vorteile der Strangkühlkörper, nämlich die gute thermische Anbindung und Wärmeverteilung im Kühlkörper, mit den Vorteilen der Schäume, nämlich der großen Oberfläche und der erhöhten Erzeugung von Turbulenzen. Im Gegensatz zu den Schäumen aus dem Stand der Technik welche aufwendig mit variierender Porengröße hergestellt werden, kann durch die vorliegende Erfindung aus einem standardisierten Ausgangsmaterial - einem offenporigen Schaum - die für die jeweilige Anwendung individuell besten Wärmeverteilstrukturen eingebracht werden.

Metallschäume können sehr günstig hergestellt werden. Kombiniert mit einer flexiblen Methode zur Kombination mit dem thermisch leitfähigen Material lassen sich deshalb günstige Kühlsysteme verwirklichen.

Die Verwendung eines Metallschaums ist insbesondere von Vorteil, da getrieben durch andere Industriethemen, insbesondere der Batterietechnik, Leichtbau u.a., sinken die Herstellkosten für Metallschäume rasant.

Vorteile bei Metallsprühen:
Da die Metallschäume auch formbar sind und das Metallsprühen mittels Roboterbasierter Führung geschieht (Beschichtung von allen Seiten möglich), ist ein hoher Freiheitsgrad bei der Herstellung vorhanden.

### KURZE BESCHREIBUNG DER ZEICHNUNGEN

Die Besonderheiten und Vorteile der Erfindung werden aus den nachfolgenden Erläuterungen mehrerer Ausführungsbeispiele anhand der schematischen Zeichnungen ersichtlich.

Es zeigen
- Fig. 1: eine schematische Darstellung eines Polymer-Dispensvorgangs,
- Fig. 2: eine schematische Darstellung eines Anbindens eines Metallschaum an eine Basisplatte,
- Fig. 3: eine schematische Darstellung eines Einbringens eines Metallpulvers,
- Fig. 4: eine schematische Darstellung eines Metallspritzverfahrens,
- Fig. 5: eine schematische Darstellung eines Herstellens einer Deckschicht und
- Fig. 6: ein Ablaufdiagramm des erfindungsgemäßen Verfahrens.

### DETAILLIERTE BESCHREIBUNG DER ERFINDUNG

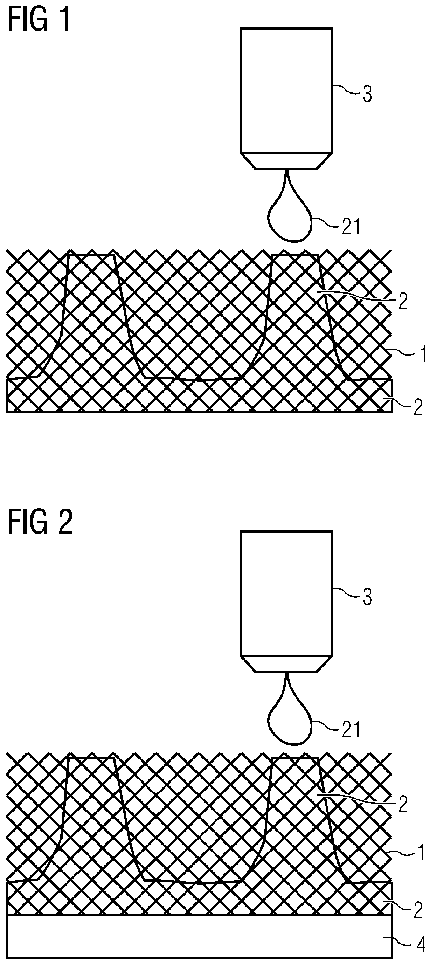

Fig. 1 zeigt einen Kühlkörper für ein Elektronikbauteil, aufweisend:
- Einen Metallschaum 1 und
- ein thermisch leitfähiges Material 2,
   wobei das thermisch leitfähige Material 2 von zumindest einem Teilbereich des Metallschaums 1 durchwachsen ist.

Im Ausführungsbeispiel ist außerdem ein Polymer-Dispensvorgang, bei dem flüssiges Polymer 21, als thermisch leitfähige Material 2, von einer Herstellvorrichtung 3 lamellenförmig in den Schaum 1 eingebracht wird, gezeigt. Dieser Vorgang kann ohne oder mit Curing (z.B. Heizen) erfolgen. Eine Erzeugung der Struktur wäre auch durch eine Schablone möglich.

Fig. 2 zeigt zusätzlich zu den Komponenten der Fig. 1 ein Anbinden von Schaum 1 an eine Basisplatte 4 (Baseplate 4) mit thermisch leitfähigen Material 2. Für die Verbindung von Schaum 1 und Baseplate 4 kann das thermisch leitfähige Material 2 ebenso benutzt werden. Hierbei wird der Schaum 1 vor dem Einbringen des thermisch leitfähige Material 2 auf die Baseplate aufgesetzt. Das thermisch leitfähige Material 2, insbesondere ein Polymer 2, "klebt" somit den Schaum 1 auf die Baseplate 4.

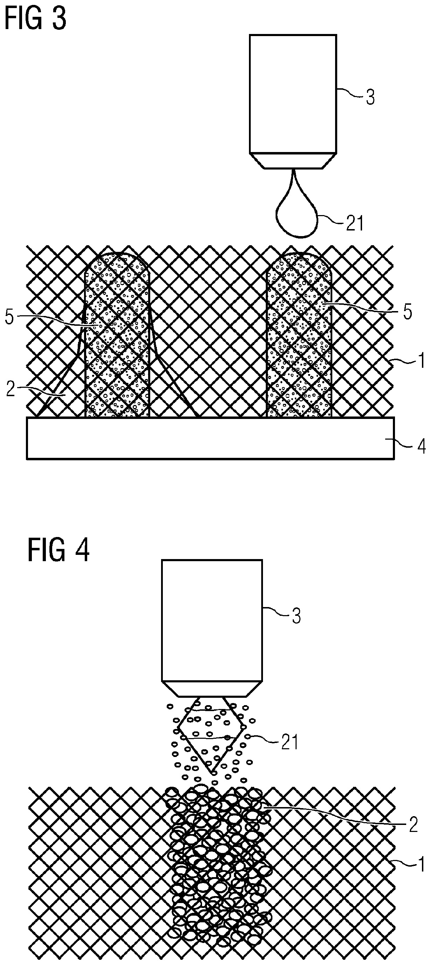

Fig. 3 zeigt zusätzlich zu den Komponenten der Fig. 1 ein Einbringen eines Metallpulvers 5 mit nachfolgender Polymerfixierung.

Fig. 4 zeigt einen Kühlkörper für ein Elektronikbauteil, aufweisend:
- Einen Metallschaum 1 und
- ein thermisch leitfähiges Material 2,
   wobei das thermisch leitfähige Material 2 von zumindest einem Teilbereich des Metallschaums 1 durchwachsen ist.

Im Ausführungsbeispiel ist außerdem ein Metallspritzverfahren, bei dem Metall als thermisch leitfähige Material 2 verwendet wird und von einer Herstellvorrichtung 3 lamellenförmig in den Schaum 1 eingebracht wird, gezeigt.

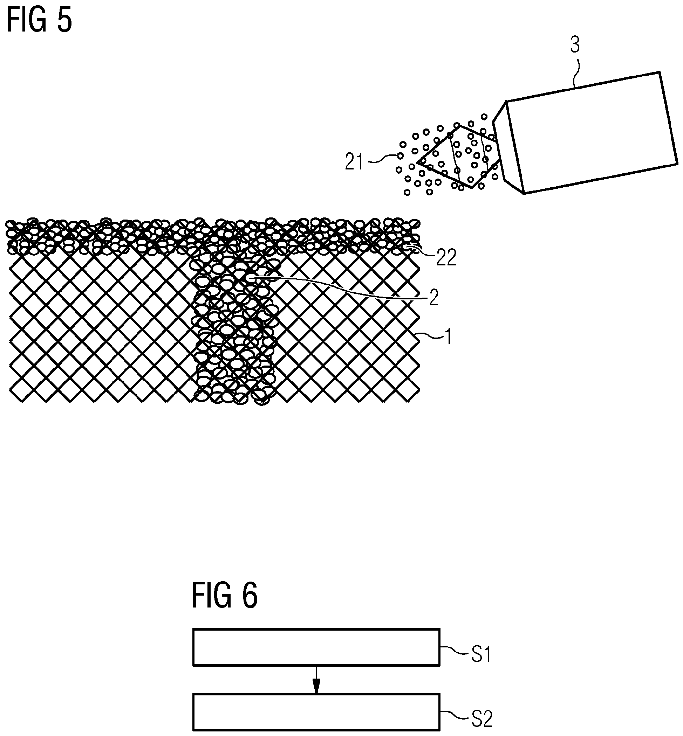

Fig. 5 zeigt ein Herstellen einer Deckschicht 22 an einer Außenseite des Metallschaums 1 mit einem Metallspritzverfahren. Durch ein Schwenken der Düse der Herstellvorrichtung 3 kann zusätzlich die Deckschicht 22 auf den Schaum 1 aufgebracht werden. Diese Deckschicht 22 kann für eine spätere Ankontaktierung (z.B. Löten, Sintern, Schweißen) an das zu kühlende Bauteil verwendet werden.

Fig. 6 zeigt ein Ablaufdiagramm einer Herstellung eines Kühlkörpers für ein Elektronikbauteil,
mit den Schritten:
- Ein Bereitstellen eines Metallschaums, wobei der Metallschaum aus einer Struktur besteht, welche durch Poren, die über Stege verbunden sind, gekennzeichnet ist, und
- ein Einbringen eines thermisch leitfähigen Materials in zumindest einen Teilbereich des Kühlkörpers, wobei das thermisch leitfähige Material nach dem Einbringen an der Struktur anliegt.

Das Einbringen erfolgt insbesondere mittels:
- eines Polymer-Dispensen-Verfahrens und/oder
- Thermischen Metallspritzverfahrens.

Obwohl die Erfindung im Detail durch die Ausführungsbeispiele näher illustriert und beschrieben wurde, ist die Erfindung durch die offenbarten Beispiele nicht eingeschränkt und andere Variationen können vom Fachmann daraus abgeleitet werden, ohne den Schutzumfang der Erfindung zu verlassen.

## Patentansprüche

1. Kühlkörper für ein Elektronikbauteil,
aufweisend:
- Einen Metallschaum (1) und
- ein thermisch leitfähiges Material (2),
wobei das thermisch leitfähige Material (2) von zumindest einem Teilbereich des Metallschaums (1) durchwachsen ist.

2. Kühlkörper nach Anspruch 1,
wobei der Metallschaum (1) aus einer Struktur besteht, welche durch Poren, die über Stege verbunden sind, gekennzeichnet ist,
wobei das thermisch leitfähige Material (2) an der Struktur anliegt.

3. Kühlkörper nach Anspruch 2,
wobei das thermisch leitfähige Material (2):
- die Struktur des Metallschaums (1) vollständig auffüllt und/oder
- an der Struktur des Metallschaums (1) als Schicht anliegt und/oder
- die Struktur des Metallschaums (1) umschließt und/oder
- die Poren des Metallschaums (1) in dem zumindest einen Teilbereich schließt und/oder
- die Poren des Metallschaums (1) in dem zumindest einen Teilbereich zumindest teilweise schließt und/oder
- die Poren des Metallschaums (1) in dem zumindest einen Teilbereich offen behält und/oder
- die Poren des Metallschaums (1) in dem zumindest einen Teilbereich zumindest teilweise offen behält.

4. Kühlkörper nach einem der vorhergehenden Ansprüche, wobei das thermisch leitfähige Material (2) in Form von:
- mindestens einer Lamelle durch den Metallschaum (1) und/oder
- mindestens eines Zylinders durch den Metallschaum (1) und/oder
- mindestens eines Kegels durch den Metallschaum (1) und/oder
- einer Deckschicht (22) an einer Außenseite des Metallschaums (1)
verläuft.

5. Kühlkörper nach einem der vorhergehenden Ansprüche,
wobei das thermisch leitfähige Material (2) ausgebildet ist als:
- mindestens ein Polymer und/oder
- ein Polymerkleber und/oder
- ein Polymer kombiniert mit Metalpartikeln und/oder
- ein Polymer kombiniert mit einem Phase-Change-Material und/oder
- mindestens ein Metall und/oder
- eine Metalllegierung.

6. Kühlkörper nach einem der vorhergehenden Ansprüche,
der Metallschaum (1) außerdem aufweisend:
- eine metallische Beschichtung, insbesondere ausgebildet als:
∘ eine Vernickelung und/oder
∘ eine Verzinnung und/oder
∘ eine Siliziumdioxidbeschichtung.

7. Kühlkörper nach einem der vorhergehenden Ansprüche,
wobei das thermisch leitfähige Material (2) ausgebildet ist, Wärme in dem Metallschaum (1) zu verteilen.

8. Kühlkörper nach einem der vorhergehenden Ansprüche,
wobei der Metallschaum (1) ausgebildet ist, von einem Kühlmedium durchströmt zu werden.

9. Kühlkörper nach einem der vorhergehenden Ansprüche,
aufweisend eine Kontaktfläche, wobei die Kontaktfläche ausgebildet ist, mit einer Basisplatte (4) des Elektronikbauteils in Kontakt zu treten.

10. Kühlkörper nach Anspruch 9,
wobei ein längster Querschnitt einer Form des thermisch leitfähigen Materials senkrecht zu der Kontaktfläche des Kühlkörpers angeordnet ist.

11. Herstellung eines Kühlkörpers für ein Elektronikbauteil, mit den Schritten:
- Ein Bereitstellen (S1) eines Metallschaums (1), wobei der Metallschaum (1) aus einer Struktur besteht, welche durch Poren, die über Stege verbunden sind, gekennzeichnet ist, und
- ein Einbringen (S2) eines thermisch leitfähigen Materials (2) in zumindest einen Teilbereich des Kühlkörpers, wobei das thermisch leitfähige Material (2) nach dem Einbringen an der Struktur anliegt.

12. Herstellung nach Anspruch 11,
wobei das Einbringen mittels:
- eines Polymer-Dispensen-Verfahrens und/oder
- Thermischen Metallspritzens
erfolgt.

13. Herstellung nach einem der Ansprüche 11 oder 12,
mit den weiteren Schritten:
- ein Aufsetzen des Metallschaums (1) auf eine Basisplatte des Elektronikbauteil vor dem Einbringen des thermisch leitfähigen Materials (2) und/oder
- ein Einbringen von Metallpartikeln (5) in den zumindest einen Teilbereich vor dem Einbringen des thermisch leitfähigen Materials (2) und/oder
- ein Einbringen eines Phase-Change-Materials in den zumindest einen Teilbereich vor dem Einbringen des thermisch leitfähigen Materials (2) und/oder
- eine chemische Vorbehandlung, insbesondere Hydrophobisierung, Hydrophilisierung oder Oxidation, des Metallschaums (1) vor dem Einbringen des thermisch leitfähigen Materials (2) und/oder
- ein Bereitstellen einer Schablone für das und vor dem Einbringen des thermisch leitfähigen Materials (2) und/oder
- ein Erhitzen nach dem Einbringen des thermisch leitfähigen Materials (2) zur Verfestigung oder zur Wärmebehandlung des thermisch leitfähigen Materials (2) und/oder
- ein Anbringen, insbesondere durch Löten, Sintern oder Schweißen, des Metallschaums (1) an einer Basisplatte (4) des Elektronikbauteil nach dem Einbringen des thermisch leitfähigen Materials (2) und/oder
- für einen Metallschaum (1), welcher Aluminium aufweist: Ein Eloxieren.

14. Herstellung nach einem der Ansprüche 11 bis 13,
wobei das Einbringen (S2) thermisch leitfähigen Materials (2) sequenziell erfolgt.

15. Herstellung nach einem der Ansprüche 11 bis 14 von ein Kühlkörpers nach einem der Ansprüche 1 bis 10.
